Europäisches Patentamt

European Patent Office

Office européen des brevets

(19)

(11) Publication number: **0 120 614**
**B1**

# EUROPEAN PATENT SPECIFICATION

(12)

(45) Date of publication of patent specification: **05.08.87**

(51) Int. Cl.⁴: **H 01 L 21/76**

(21) Application number: **84301289.9**

(22) Date of filing: **28.02.84**

(54) **Method of manufacturing a semiconductor device having isolation regions.**

(30) Priority: **28.02.83 JP 30996/83**

(43) Date of publication of application:
**03.10.84 Bulletin 84/40**

(45) Publication of the grant of the patent:
**05.08.87 Bulletin 87/32**

(84) Designated Contracting States:
**DE GB NL**

(56) References cited:
**EP-A-0 020 994**
**EP-A-0 023 146**
**EP-A-0 061 855**
**US-A-4 233 091**

**IBM TECHNICAL DISCLOSURE BULLETIN, vol.
20, no. 1, June 1977, pages 144-145, New York,
USA S.A. ABBAS: "Recessed oxide isolation
process"**

(73) Proprietor: **Oki Electric Industry Company,
Limited
7-12, Toranomon 1-chome Minato-ku
Tokyo 105 (JP)**

(72) Inventor: **Yoshioka, Kentaro Oki Electric
Industry Co. Ltd.
7-12 Toranomon 1-chome
Minato-Ku Tokyo (JP)**

(74) Representative: **Crawford, Andrew Birkby et al
A.A. THORNTON & CO. Northumberland House
303-306 High Holborn
London WC1V 7LE (GB)**

Courier Press, Leamington Spa, England.

## Description

### Background of the Invention

This invention relates to a method of manufacturing semiconductor devices having miniaturized element isolation regions.

### Prior Art

Recently, the degree of miniaturization of integrated circuits of semiconductor devices has become remarkably high, and this has depended much on advances in manufacturing techniques.

Particularly, the selective oxidation method is one of the most important methods of manufactures for isolation between elements, and this method has been utilized frequently. The selective oxidation method is disclosed in Japanese Patent Publication No. 49916 (1972) as a LOCOS (Local Oxidation of Silicon) method.

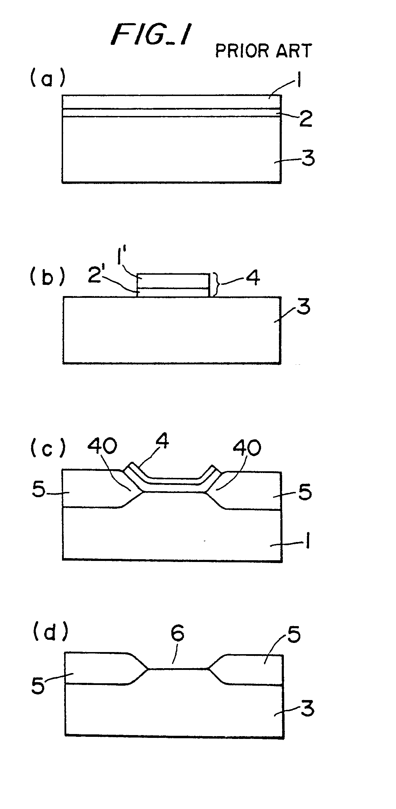

For example, Figs. 1(a) through (d) show steps of manufacturing semiconductor device utilizing a prior art LOCOS method. Firstly, as shown in Fig. 1(a), a thin heat-grown oxide film 2 is formed on a silicon semiconductor substrate 3, and after which a nitride film 1 is formed by the CVD method on the surface of the oxide film 2. Then, as shown in Fig. 1(b), an oxidation-resisting mask region 4 consisting of a nitride film 1' and an oxide film 2' is formed. Successively, as shown in Fig. 1(c), the substrate is subjected to oxidation treatment to form a thick field oxide film region 5 for isolation of elements. Thereafter, an active region 6 is obtained by removing the mask region 4 as shown in Fig. 1(d).

However, with the conventional LOCOS method, bird beak's regions are also produced below the end portions of the mask region 4 as shown in Fig. 1(c). Accordingly, dead spaces are produced by the bird beak's regions intruding into the oxidation-resisting mask region, whereby the width of the element isolation region is increased.

As it is necessary to increase the dimension of the oxidation-resisting mask pattern by the dimension of the bird-beak's region intruding below the oxidation-resisting mask region, it becomes difficult to control the width of the element isolation region.

Particularly, in the case where an active region for a MOS transistor element is to be formed, when the gate width is decreased above the designed value due to the intrusion of the bird beak's region, a narrow channel effect appears where the threshold value of the MOS transistor is increased.

As a result, with the prior art LOCOS method, the bird beak's region made it difficult to realize an LSI having higher densities.

IBM Technical Disclosure Bulletin, Vol. 20 No. 1 June 1977 pp. 144, 145 discloses a method of selectively oxidising a silicon substrate in order to produce insulating regions comprising substantially vertical blocks of recessed silicon dioxide, the method comprising (1) etching a hole in the substrate (2) oxidising the substrate surface and the surface of the hole to provide an $SiO_2$ layer 50 nm (500 Å) thick, (3) providing a layer of silicon nitride 50 nm (500 Å) thick on the $SiO_2$ layer, (4) evaporating polysilicon on the surface to about half the hole depth, (5) etching the polysilicon from the substrate surface, and (6) oxidising the polysilicon in the hole to the height of the substrate surface.

It is an object of this invention to overcome the problems of the prior art.

The present invention provides a method of making a semiconductor device having element isolation regions comprising the steps of:

forming an etching mask layer (61) on the entire surface of a silicon substrate (62);

removing selectively said etching mask layer to form an opening exposing a desired surface of said silicon substrate;

dry-etching said exposed surface of said silicon substrate to form a recess (63);

removing the remainder of said etching mask layer and forming a thin thermally grown silicon oxide film (64) on the entire surface of said silicon substrate and on the entire surface in said recess, said thin silicon oxide film being 50 to 200 nm (500 to 2000 Å) in thickness;

forming a thick insulating film (65) on the entire surface of said thin silicon oxide film by reduced pressure CVD process, said insulating film being of $SiO_2$ or PSG having a thickness of 0.5 to 2 μm;

forming a thick polycrystalline silicon film (68) on the entire surface of said insulating layer by CVD process, said polycrystalline silicon film being 0.5 to 3 μm in thickness;

forming a polyimide resin layer over the entire surface of said polycrystalline silicon film;

dry-etching at a uniform etching rate said polyimide resin layer and said polycrystalline silicon film to expose said surface of said thick insulating film (65) while leaving a portion (69) of said polycrystalline silicon film in said recess; and either

(A) oxidising the surface of said portion of said polycrystalline silicon film to form a silicon oxide region (71) thereon; and

etching off thin thermally grown silicon oxide film over said silicon substrate to expose portions (86, 87) of the surface thereof, thus forming said element isolation region in said recess, or

(B) removing said polycrystalline silicon film (68) and said thick insulating film (65) on said surface of said silicon substrate by using an etching solution of a hydrofluoric acid type to expose a surface of said thin grown silicon oxide film (64) while leaving a portion of said polycrystalline silicon film (69) in said recess;

oxidizing the resulting assembly to convert said exposed surface of said remaining polycrystalline silicon film and the surface of said silicon substrate into a silicon oxide form (105, 106); and

etching off said silicon oxide film on the resulting assembly to expose the surface of said silicon substrate (86, 87), thus forming an element isolation region in said recess.

In the accompanying drawings:

Figs. 1(a) through (d) show steps of the prior art method for forming element isolation region, respectively;

Figs. 2(a) through (h) show successive steps of manufacturing a semiconductor device having element isolation regions according to one embodiment of this invention, respectively;

Figs. 3(a) through (c) show successive steps of manufacturing a semiconductor device according to the second embodiment of this invention, respectively.

Preferred Embodiments

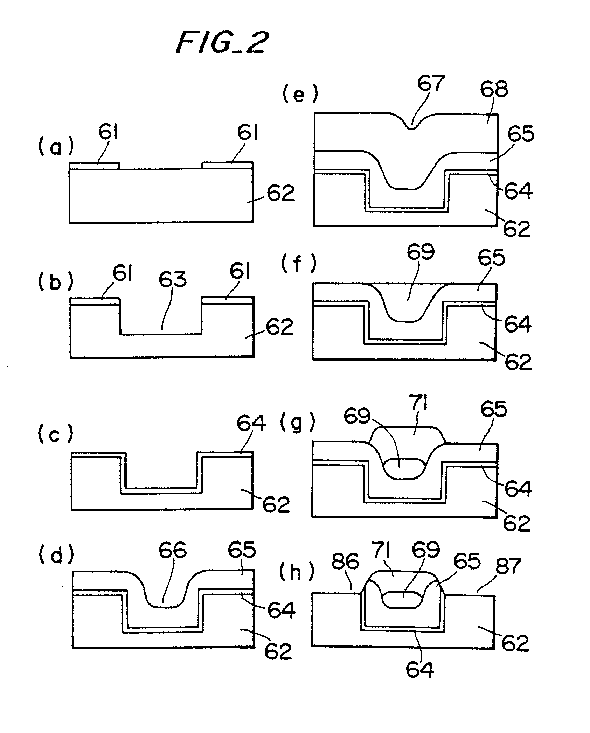

An embodiment of the method of manufacturing semiconductor device according to this invention will now be described referring to the drawings. Fig. 2(a) through (h) show successive steps describing one embodiment. As shown in Fig. 2(a), an etching mask layer 61, such as a photoresist, is formed on entire surface of a substrate 62, after which the etching is removed selectively to expose desired surface of the silicon substrate.

Successively, as shown in Fig. 2(b), a recess 63, having a depth of 0.5 to 2 μ, for example, is formed by means of a dry etching in a silicon substrate 62 using an etching mask layer 61 as a mask.

Thereafter, as shown in Fig. 2(c), a thin heat-grown silicon oxide film 64, having a thickness of 50 to 200 nm (500 to 2000 Å), for example, is formed on entire surface of the silicon substrate 62.

Then, as shown in Fig. 2(d), a thick insulation film 65, having a thickness of 0.5 to 2 μ, for example, made of PSG or SiO$_2$ is formed on the silicon oxide film 64 by reduced pressure CVD process.

In this case, the recess 66 is formed to have a form substantially the same as that of the recess 63.

Thereafter, as shown in Fig. 2(e), a thick polycrystalline silicon film 68 or polycrystalline silicon film 68 containing phosphor having a thickness of 0.5 to 3 μ is deposited on the insulating film 65 using CVD method. Generally, the CVD polycrystalline silicon film has a remarkably excellent characteristic in step coverage, so that the surface of the film 68 becomes substantially flat.

Then, by coating a polyimide resin layer, for example, (not shown) over the entire surface of the polycrystalline silicon film 68 with a thickness of about 1 to 2 μ, making the surface perfectly flat.

Next, as shown in Fig. 2(f), the polyimide resin and the polycrystalline silicon film 68 are removed by dry etching process at the same speed, until the surface of the insulating film 65 is exposed. Whereby the polycrystalline silicon region 69 is left in the recess formed by the insulation film 65.

Thereafter, as shown in Fig. 2(g), by heat-oxidizing the polycrystalline silicon region 69 in an oxygen atmosphere, the surface of the polycrystalline silicon region 69 is converted into a heat-grown silicon oxide region 71.

Then, as shown in Fig. 2(h), the entire surfaces of the CVD insulating film 65 and the silicon oxide region 71 are etched and removed by the etching solution of hydrofluoric acid type for example. By this means, since the etching speed of the heat-grown silicon oxide is smaller than that of the CVD insulating material, the exposed CVD insulating film 65 is removed perfectly, and the surface of the silicon substrate is exposed as shown in Fig. 2(h), the active regions 86 and 87 are obtained.

Accordingly, the element isolation regions formed by heat-grown silicon oxide films 64, 71, CVD insulating film 65 and polycrystalline silicon region 69 can be formed.

In the first embodiment described above, one example of the present invention is shown, but the effect or merit of this invention can fully be attained also by the following method.

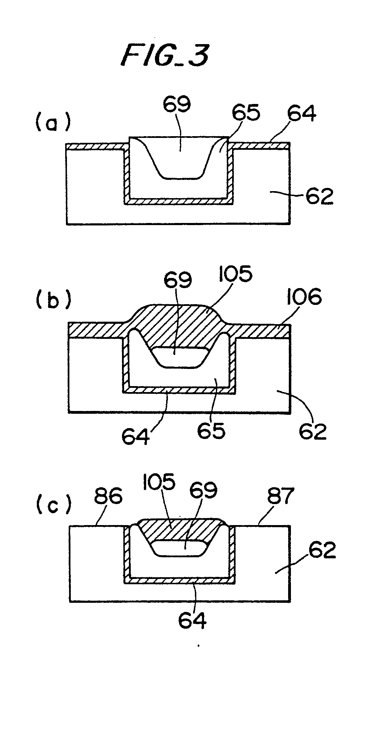

Thus, after obtaining the form shown in Fig. 2(f), using an etching solution of a hydrofluoric acid type which does not etch the polycrystalline silicon film 69, the exposed insulating layer 65 is etched off quickly as shown in Fig. 3(a). At this time, since the etching speed of the heat-oxidized film 64 is slower than that of the insulating film 65, the former remains as it is exposed.

Then, whole of the semiconductor substrate is heat treated in an oxidizing atmosphere to obtain the oxidized region 105 of the polycrystalline silicon and the silicon oxide film 106.

It will be evident that the effect of the invention will not be affected even when all of the polycrystalline silicon region 69 is converted into silicon oxide.

Generally, the oxidation speed of a polycrystalline silicon containing phosphor is larger than that of the mono-crystalline silicon by 1.3 to 2 times, so that it is possible to make the thickness of the oxide film 105 to be sufficiently larger than that of the oxide film 106.

Thereafter, as shown in Fig. 3(c), the oxide film 106 exposed on the silicon substrate 62 is etched off to obtain the element isolation region the same as that shown in Fig. 2.

As described above, according to the method of this invention, the heat-grown silicon oxide film in the element isolation recess formed initially in the silicon substrate is maintained throughout whole the process, so that the bird beak's region will not be produced. As the result, the element isolation region can be miniaturized, and it is not necessary to consider, with respect thereto, on adverse effect due to above-said bird beak's region.

Accordingly, the method of manufacturing semiconductor device according to the present invention can sufficiently be applicable not only to the manufacture of a MOS type semiconductor device having an active region surrounded by extremely and accurately miniaturized element isolation region but also to the manufacture of a bipolar type semiconductor device having an inductive isolation construction.

**Claims**

1. A method of making a semiconductor device having element isolation regions comprising the steps of:

forming an etching mask layer (61) on the entire surface of a silicon substrate (62);

removing selectively said etching mask layer to form an opening exposing a desired surface of said silicon substrate;

dry-etching said exposed surface of said silicon substrate to form a recess (63);

removing the remainder of said etching mask layer and forming a thin thermally grown silicon oxide film (64) on the entire surface of said silicon substrate and on the entire surface in said recess, said thin silicon oxide film being 50 to 200 nm (500 to 2000 Å) in thickness;

forming a thick insulating film (65) on the entire surface of said thin silicon oxide film by reduced pressure CVD process, said insulating film being of $SiO_2$ or PSG having a thickness of 0.5 to 2 µm;

forming a thick polycrystalline silicon film (68) on the entire surface of said insulating layer by CVD process, said polycrystalline silicon film being 0.5 to 3 µm in thickness;

forming a polyimide resin layer over the entire surface of said polycrystalline silicon film;

dry-etching at a uniform etching rate said polyimide resin layer and said polycrystalline silicon film to expose said surface of said thick insulating film (65) while leaving a portion (69) of said polycrystalline silicon film in said recess; and either

(A) oxidizing the surface of said portion of said polycrystalline silicon film to form a silicon oxide region (71) thereon; and

etching off thin thermally grown silicon oxide film over said silicon substrate to expose portions (86, 87) of the surface thereof, thus forming said element isolation region in said recess; or

(B) removing said polycrystalline silicon film (68) and said thick insulating film (65) on said surface of said silicon substrate by using an etching solution of a hydrofluoric acid type to expose a surface of said thin grown silicon oxide film (64) while leaving a portion of said polycrystalline silicon film (69) in said recess;

oxiding the resulting assembly to convert said exposed surface of said remaining polycrystalline silicon film and the surface of said silicon substrate into a silicon oxide film (105, 106); and

etching off said silicon oxide film on the resulting assembly to expose the surface of said silicon substrate (86, 87), thus forming an element isolation region in said recess.

2. A method according to claim 1 wherein said polycrystalline silicon film contains phosphor and is deposited by a reduced pressure CVD process.

## Patentansprüche

1. Verfahren zum Herstellen einer Halbleiteranordnung mit Elemente isolierenden Bereichen, wobei das Verfahren die Schritte umfaßt:

Bilden einer Ätzmaskenschicht (61) auf der gesamten Oberfläche eines Siliciumsubstrats (62),

selektives Entfernen der Ätzmaskenschicht, um eine Öffnung zu bilden, die eine erwünschte Oberfläche des Siliciumsubstrats freilegt,

trockenes Ätzen der freigelegten Oberfläche des Siliciumsubstrats, um eine Ausnehmung (63) zu bilden,

Entfernen des Restes der Ätzmaskenschicht und Ausbilden einer dünnen, thermisch gewachsenen Siliciumoxidschicht (64) auf der gesamten Oberfläche des Siliciumsubstrats und auf der gesamten Oberfläche in der Ausnehmung, wobei die dünne Siliciumoxidschicht eine Dicke von 50 bis 200 nm (500—2.000 Å) aufweist,

Ausbilden einer dicken Isolierschicht (65) auf der gesamten Oberfläche der dünnen Siliciumoxidschicht mittels eines Kathodenverdampfungs-Niederschlagverfahrens bei verringertem Druck, wobei die Isolierschicht aus $SiO_2$ oder PSG mit einer Dicke von 0,5 bis 2 µm besteht,

Ausbilden einer dicken, polykristallinen Siliciumschicht (68) auf der gesamten Oberfläche der Isolierschicht mittels eines Kathodenverdampfungs-Niederschlagverfahrens, wobei die polykristalline Siliciumschicht eine Dicke von 0,5 bis 3 µm aufweist,

Ausbilden einer Polyimidkunstharzschicht auf der gesamten Oberfläche der polykristallinen Siliciumschicht,

trockenes Ätzen der Polyimidkunstharzschicht und der polykristallinen Siliciumschicht mit einer gleichförmigen Ätzrate, um die Oberfläche der dicken Isolierschicht (65) freizulegen, während ein Teilstück (69) der polykristallinen Siliciumschicht in der Ausnehmung verbleibt, und entweder

(A) Oxidieren der Oberfläche des Teilstücks der polykristallinen Siliciumschicht, um auf diesem einen Siliciumoxidbereich (71) auszubilden, und

Abätzen der dünnen, thermisch gewachsenen Siliciumoxidschicht auf dem Siliciumsubstrat, um Bereiche (86, 87) seiner Oberfläche freizulegen, wodurch der Elemente isolierende Bereich in der Ausnehmung gebildet wird, oder

(B) Entfernen der polykristallinen Siliciumschicht (68) und der dicken Isolierschicht (65) von der Oberfläche des Siliciumsubstrats, indem eine Ätzlösung vom Fluorwasserstoffsäuretyp verwendet wird, um eine Oberfläche der dünnen, gewachsenen Siliciumoxidschicht (64) freizulegen, während ein Teilstück der polykristallinen Siliciumschicht (69) in der Ausnehmung verbleibt,

Oxidieren der sich ergebenden Anordnung, um die freigelegte Oberfläche der verbliebenen polykristallinen Siliciumschicht und die Oberfläche des Silicumsubstrats in eine Siliciumoxidschicht (105, 106) umzuwandeln, und

Abätzen der Siliciumoxidschicht auf der sich ergebenden Anordnung, um die Oberfläche des Siliciumsubstrats (86, 87) freizulegen, wodurch ein Elemente isolierender Bereich in der Ausnehmung gebildet wird.

2. Verfahren nach Anspruch 1, bei dem die polykristalline Siliciumschicht Phosphor enthält und mittels eines Kathodenverdampfungs-Niederschlagverfahrens bei verringertem Druck aufgebracht wird.

## Revendications

1. Un procédé pour fabriquer un dispositif à semiconducteur ayant des zones d'isolation d'éléments, comprenant les étapes suivantes:

— formation d'une couche (61) de masque de gravure sur la surface entière du substrat de silicium (62);

— enlèvement sélectif de ladite couche de masque de gravure pour former une ouverture exposant une surface désirée dudit substrat de silicium;

— gravure à sec de ladite surface exposée de ce substrat de silicium pour former une cavité (63);

— enlèvement du reste de la couche de masque de gravure et formation d'un film d'oxyde de silicium mince, croissant thermiquement, (64) sur la surface entière dudit substrat de silicium et sur la surface entière dans ladite cavité, ledit film mince d'oxyde de silicium ayant une épaisseur de 50 à 200 nm;

— formation d'un film isolant épais (65) sur la surface entière dudit film mince d'oxyde de silicium par le procédé CVD sous pression réduite, ce film isolant étant du $SiO_2$ ou PSG ayant une épaisseur de 0,5 à 2 µm;

— formation d'un film de silicium polycristallin épais (68) sur la surface entière de ladite couche isolante par le procédé CVD, ce film de silicium polycristallin ayant une épaisseur de 0,5 à 3 µm;

— formation d'une couche de résine de polyimide sur la surface entière dudit film de silicium polycristallin;

— gravure à sec, à un taux de gravure uniforme, de ladite couche de résine de polyimide et dudit film de silicium polycristallin pour exposer la surface dudit film isolant épais (65) en laissant une portion (69) de ce film de silicium polycristallin dans ladite cavité; et soit

(A) — oxydation de la surface de ladite portion dudit film de silicium polycristallin pour y former une zone d'oxyde de silicium (71); et

— enlèvement par gravure du film d'oxyde de silicium mince, croissant thermiquement, sur ce substrat de silicium pour exposer les portions (86, 87) de sa surface, formant ainsi cette zone d'isolation d'éléments dans cette cavité; soit

(B) — enlèvement dudit film de silicium polycristallin (68) et dudit film isolant épais (65) sur ladite surface dudit substrat de silicium par utilisation d'une solution de gravure du type acide fluorhydrique pour exposer une surface dudit film d'oxyde de silicium mince, croissant, (64) tout en laissant une portion dudit film de silicium polycristallin (69) dans ladite cavité;

— oxydation de l'ensemble résultant pour convertir ladite surface exposée dudit film de silicium polycristallin restant et la surface dudit substrat de silicium en un film d'oxyde de silicium (105, 106); et

— enlèvement par gravure dudit film d'oxyde de silicium sur l'ensemble résultant pour exposer la surface dudit substrat de silicium (86, 87), formant ainsi une zone d'isolation d'élément dans ladite cavité.

2. Un procédé selon la revendication 1, selon lequel ledit film se silicium polycristallin contient du phosphore et est déposé par un procédé CVD sous pression réduite.

0 120 614

## FIG_1  PRIOR ART

(a)

(b)

(c)

(d)

## FIG_2

## FIG_3

(a)

(b)

(c)